# FASCICULE DE BREVET EUROPEEN

(11) **EP 1 333 481 B1**
(45) Date de publication et mention de la délivrance du brevet: **08.08.2018**
(21) Numéro de dépôt: 03290213.2
(22) Date de dépôt: 28.01.2003
(51) Int. Cl.: H01L 21/60, B23K 1/005, H05K 3/32

(54) **Procédé de soudage de conducteurs sur des substrats**
Verfahren zum Löten von Leitern auf Substrate
Process for soldering leads on substrates

(30) Priorité: 31.01.2002 FR 0201128
(43) Date de publication de la demande: 06.08.2003
(73) Titulaire: Valeo Electronique et Systemes de Liaison, 78180 Montigny le Bretonneux (FR)
(72) Inventeur: Vivet, Laurent, 78390 Bois d'Arcy (FR); Gombeau, Murielle, 45160 Olivet (FR)
(74) Mandataire: Eidelsberg, Olivier Nathan

(56) Documents cités:
- EP-A- 1 093 880
- EP-A- 1 118 412
- FR-A1- 2 802 765
- US-A- 4 697 061
- US-A- 5 175 410
- US-A- 5 194 710
- US-A- 5 763 854

## Description

La présente invention vise le soudage de conducteurs électriques tels que des bandes métalliques souples ou rigides sur des substrats tels que SMI (substrat métal isolé) DBC (direct bonding copper).

En raison des forts courants véhiculés, la composition volumique des conducteurs est généralement à base de cuivre.

Plusieurs techniques ont été utilisées pour le soudage de conducteurs sur des substrats. On a essayé la soudure électrique mais celle-ci s'avère très difficile du fait de la très grande conductivité électrique du cuivre, l'échauffement étant insuffisant. Pour remédier à cet inconvénient, on a imaginé d'utiliser des électrodes en tungstène qui engendrent un fort échauffement au passage du courant ; la chaleur des électrodes se propage rapidement dans les pièces en cuivre à souder, ce qui a pour effet d'augmenter la résistance électrique du cuivre.

On a également utilisé la soudure par faisceau d'électrons, mais celle-ci ne peut être réalisée que sous vide et en mode continu. De plus, ce procédé induit la démagnétisation des pièces voisines.

Au document US 4 697 061, il est décrit un procédé suivant le préambule de la revendication 1. Le document FR2802765 divulgue un dispositif de brasage laser de composants électroniques et/ou électriques sur circuits fins. La présente invention vise un procédé qui remédient à ces inconvénients.

Le procédé, selon l'invention, est tel que défini à l'une des revendications 1 à 6.

Grâce à cette disposition, le plot évite tout échauffement préjudiciable au substrat et la surface du conducteur est chauffée par les radiations absorbées par le matériau. Les radiations laser étant focalisées sur de faibles surfaces, elles engendrent de très fortes densités de puissance de sorte que le métal est vaporisé. La détente de vapeur provoque une pression de recul qui, appuyant sur le bain liquide sous-jacent, provoque le déplacement du matériau liquéfié du centre de la tache laser vers les bords. Un capillaire de gaz chaud se forme et pénètre en profondeur tant que la pression, au fond du capillaire, est suffisante. Le métal vaporisé s'ionise en formant un plasma qui s'échauffe.

De préférence, on utilise un plot dont les dimensions sont légèrement supérieures à celles d'une extrémité du conducteur destinée à être soudée sur ce plot afin de faciliter la soudure dans les parties médianes dudit conducteur.

Suivant encore une autre caractéristique du procédé selon l'invention, on revêt le conducteur, préalablement à la soudure par point, celui-ci étant par exemple nickelé.

De préférence, les points de soudure sont disposés en X. Ils peuvent également être disposés en W. Le procédé selon l'invention utilise un équipement pour la mise en oeuvre du procédé ci-dessus, ledit équipement étant du type comprenant une embase avec des moyens de guidage et de positionnement du substrat, des moyens de guidage d'une extrémité d'un conducteur, des moyens pour appliquer contre le plot ladite extrémité et un bâti supportant une tête de soudage laser reliée à des moyens d'alimentation et de commande convenables, ledit équipement étant caractérisé en ce que sur le bâti est fixée une extrémité d'un bras dont l'autre extrémité supporte des déflecteurs qui sont prolongés par des guides qui constituent les moyens de guidage de l'extrémité du conducteur, le bâti étant mobile le long d'une potence s'érigeant à partir de l'embase, tandis que cette dernière présente des rainures pour le guidage du substrat et une butée escamotable pour son positionnement.

Suivant encore une autre caractéristique, les moyens de guidage et les moyens pour appliquer l'extrémité du conducteur contre le plot comportent une semelle en un matériau réfractaire à faible conductivité thermique.

De préférence, la semelle en matériau réfractaire à faible conductivité thermique est en tungstène.

L'invention va maintenant être décrite avec plus de détails en se référant à un mode de réalisation particulier donné à titre d'exemple seulement et représenté aux dessins annexés.

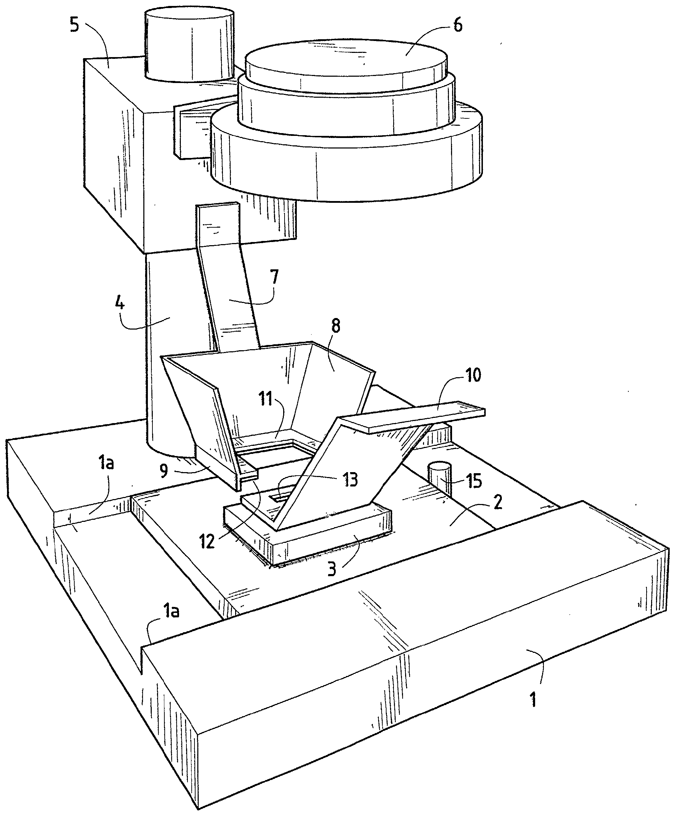

Figure 1 est une vue en perspective d'un équipement, utilisé dans le procédé selon l'invention.
Figure 2 est une vue en perspective montrant les points de soudure.
Figure 3 est encore une vue en perspective montrant une variante de disposition des points de soudure.

L'équipement représenté sur la figure comprend une embase 1 avec des rainures la de guidage d'un substrat 2 et une butée escamotable 15 calant celui-ci dans la position de soudage. Le substrat comprend une base en aluminium, une couche d'un polymère et une mince couche de cuivre sur laquelle on a brasé préalablement un plot 3 en cuivre ou alliage à base de cuivre et qui présente une sous couche nickel.

A partir de l'embase 1 s'érige une potence 4 le long de laquelle est mobile un bâti 5.

Le bâti 5 supporte rigidement une tête de soudage laser 6 du type permettant le déplacement du faisceau par des miroirs galvanométriques.

Sur le bâti 5 est fixée l'une des extrémités d'un bras 7 dont l'autre extrémité supporte des déflecteurs 8 prolongés par des guides 9 pour le centrage et le guidage d'un conducteur 10. Les déflecteurs 8 présentent un rebord interne 11 sous lequel s'étend une semelle en tungstène 12.

Le conducteur 10 a une épaisseur inférieure à 1 mm et on peut, par poinçonnage, réaliser dans la zone à souder un amincissement 13 notamment dans les cas où l'épaisseur est supérieure à 1 mm.

Le conducteur 10 est de préférence nickelé afin de faciliter l'absorption initiale du rayonnement laser par sa face supérieure, le nickel produisant, avec le cuivre, une solution solide illimitée.

Le plot 3 a des dimensions légèrement supérieures à celles de l'extrémité du conducteur 10 afin de faciliter la soudure par recouvrement.

La composition volumique du plot 3 est identique à celle du conducteur 10 afin de diminuer le risque de former des alliages à bas point de solidification propices à la fissuration à chaud.

Le bâti 5 est déplacé le long de la potence 4 afin de permettre la mise en place du substrat 2 entre les rainures de guidage la, celui-ci étant bloqué par la butée escamotable 15, le conducteur 10 étant, par son extrémité correspondante, glissé sous la semelle en tungstène 12 et maintenu par les guides 9, le bâti 5 étant descendu afin que la partie à souder du conducteur soit fermement appliquée contre le plot 3, ainsi on évite les projections et on assure une bonne reproductibilité de la soudure. Après soudure, la butée 15 est effacée et le substrat 2 et le conducteur 10 sont dégagés et remplacés par deux autres éléments à assembler.

La tête laser 6 et les moyens de maintien du conducteur contre le plot étant portés par le bâti 5, on est assuré du bon positionnement de ces éléments pour garantir les points de soudure.

Lors de la soudure, les déflecteurs 7 permettent de récupérer les projections résiduelles.

Les points de soudure 16 sont disposés en X afin de limiter les mouvements du conducteur autour d'un axe préférentiel lorsque le conducteur et le plot sont soumis à des contraintes mécaniques ou des vibrations.

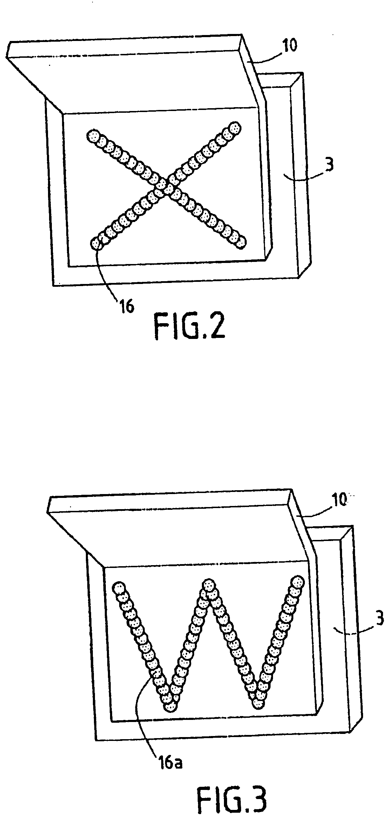

On peut également comme représenté à la figure 3 réaliser les points de soudure 16a de manière qu'ils forment un W.

## Revendications

1. Procédé de soudage de conducteurs (10) sur des substrats, dans lequel un plot (3) est solidarisé avec le substrat (2), en utilisant un dispositif de soudage au laser ayant une embase (1), comportant les étapes qui consistent à positionner le substrat (2) sur l'embase (1) et à presser la partie du conducteur à souder contre le plot, **caractérisé par** l'étape qui consiste à solidariser le conducteur avec le plot par une soudure par point à l'aide du dispositif de soudage laser, le plot ayant la même composition volumique que le conducteur.

2. Procédé selon la revendication 1, **caractérisé en ce qu'**on utilise un plot dont les dimensions sont supérieures à celles d'une extrémité du conducteur destinée à être soudée sur le plot.

3. Procédé selon la revendication 1, **caractérisé en ce qu'**on revêt le conducteur, préalablement à la soudure par point.

4. Procédé selon la revendication 3, **caractérisé en ce que**, préalablement à la soudure par point, on nickèle le conducteur.

5. Procédé selon la revendication 1, **caractérisé en ce que** les points de soudure (16) sont disposés en X.

6. Procédé selon la revendication 1, **caractérisé en ce que** les points de soudure sont disposés en W.

## Patentansprüche

1. Verfahren zum Schweißen von Leitern (10) auf Substrate, bei dem ein Klötzchen (3) mit dem Substrat (2) fest verbunden ist, unter Verwendung einer Vorrichtung zum Laserschweißen, die einen Sockel (1) aufweist, umfassend die Schritte, welche darin bestehen, das Substrat (2) auf dem Sockel (1) zu positionieren und den zu schweißenden Teil des Leiters gegen das Klötzchen zu drücken, **gekennzeichnet durch** den Schritt, welcher darin besteht, den Leiter durch eine Punktschweißung mit Hilfe der Laserschweißvorrichtung fest mit dem Klötzchen zu verbinden, wobei das Klötzchen die gleiche Volumenzusammensetzung wie der Leiter aufweist.

2. Verfahren nach Anspruch 1, **dadurch gekennzeichnet, dass** ein Klötzchen verwendet wird, dessen Abmessungen größer sind als diejenigen eines Endes des Leiters, das dazu bestimmt ist, an das Klötzchen geschweißt zu werden.

3. Verfahren nach Anspruch 1, **dadurch gekennzeichnet, dass** der Leiter vor der Punktschweißung beschichtet wird.

4. Verfahren nach Anspruch 3, **dadurch gekennzeichnet, dass** der Leiter vor der Punktschweißung vernickelt wird.

5. Verfahren nach Anspruch 1, **dadurch gekennzeichnet, dass** die Schweißpunkte (16) X-förmig angeordnet sind.

6. Verfahren nach Anspruch 1, **dadurch gekennzeichnet, dass** die Schweißpunkte W-förmig angeordnet sind.

## Claims

1. A method of welding conductors (10) to substrates, in which a stud (3) is fixed to said substrate (2), using a laser welding device comprising a base (1), the method comprising:
positioning the substrate (2) on the base (1), and
pressing the portion of the conductor to weld against the stud;
**characterized by** the step of fixing the conductor to the stud by a spot welding with the laser welding device,
the stud and the conductor having the same composition by volume.

2. The method of claim 1, **characterized in that** a stud is used which comprises dimensions that are greater than those of an end of the conductor to be welded on the stud.

3. The method of claim 1, **characterized in that** it comprises coating the conductor, prior to the spot welding.

4. The method of claim 3, **characterized in that** comprising nickel plating the conductor prior to spot welding.

5. The method of claim 1, **characterized in that** the spot welding comprises forming a X-shaped weld pattern (16).

6. The method of claim 1, **characterized in that** the spot welding comprises forming a W-shaped weld pattern.
